Europäisches Patentamt

European Patent Office

Office européen des brevets

(19)

(11) Veröffentlichungsnummer: **0 081 242**
**A2**

(12) **EUROPÄISCHE PATENTANMELDUNG**

(21) Anmeldenummer: **82111363.6**

(22) Anmeldetag: **08.12.82**

(51) Int. Cl.³: **H 05 K 13/04**

(30) Priorität: **09.12.81 DE 3148673**

(43) Veröffentlichungstag der Anmeldung:
**15.06.83 Patentblatt 83/24**

(84) Benannte Vertragsstaaten:
**DE FR GB IT NL**

(71) Anmelder: **ROBERT BOSCH GMBH**
**Postfach 50**
**D-7000 Stuttgart 1(DE)**

(72) Erfinder: **Drexel, Peter**
**Plieningerstrasse 33**
**D-7031 Steinenbronn(DE)**

(72) Erfinder: **Hecht, Dieter, Ing. grad.**
**Königseestrasse 20**
**D-7000 Stuttgart 50(DE)**

(54) **Vorrichtung zum Bestücken von Leiterplatten mit plättchenförmigen elektronischen Bauelementen.**

(57) Es wird eine Vorrichtung zum Bestücken von Leiterplatten (15) mit plättchenförmigen elektronischen Bauelementen (33) vorgeschlagen, bei welcher die Bauelemente (33) in einem Bündel von röhrchenförmigen Magazinen (32) gestapelt sind, welches das gleiche Raster wie das Layout der Leiterplatte (15) hat. Die Bauelemente (33) treten aus den Magazinen (32) in Fenster (66) einer Schieberplatte (20), welche die Bauelemente (33) unter ein Bündel von Saugröhrchen (50) schiebt. Diese erfassen die Bauelemente (33) und setzen sie durch eine Axialbewegung auf die Leiterplatte (15) auf. Die Schieberplatte (20) ist vorzugsweise unterhalb der Magazine (32) angeordnet, so daß die Bauelemente (33) unter dem Einfluß der Schwerkraft in die Fenster (66) der Schieberplatte (20) gelangen. Dadurch ergibt sich ein einfacher Antrieb mit einer geringen Anzahl von Antriebsgliedern und Bewegungsspielen. Zum Abdecken der Fenster (66) beim Quertransport zu den Saugröhrchen (50) kann vorteilhaft eine Blendenplatte (22) vorgesehen sein, die relativ zur Schieberplatte (20) bewegbar ist.

EP 0 081 242 A2

Croydon Printing Company Ltd

R. 17453
29.10.1981 Ki/Pi


ROBERT BOSCH GMBH, 7000 STUTTGART1



Vorrichtung zum Bestücken von Leiterplatten mit
plättchenförmigen elektronischen Bauelementen


Stand der Technik


Die Erfindung geht aus von einer Vorrichtung nach der
Gattung des Hauptanspruchs. Beim Bestücken von Leiterplatten mit plättchenförmigen elektronischen Bauelementen, sogenannten Chips, kommt es wegen des hohen
Miniaturisierungsgrades dieser Schaltungstechnik auf
eine sehr genaue Postionierung der Bauelemente auf
der Leiterplatte an. Die Bauelemente selbst sind so
klein und dünn, daß die Vorrichtungsteile zum Halten
und Transportieren der Bauelemente sehr maßgenau ausgeführt und zueinander angeordnet sein müssen. Aus
diesen Gründen kommt eine Arbeitsweise, wie sie für
das Bestücken von Leiterplatten mit etwas größeren
zylindrischen Bauelementen bekanntgeworden ist (GB-PS
14 77 027) und bei welcher die durch einen Schieber
vereinzelten Bauelemente unter dem Einfluß der Schwerkraft aus einer Maske auf die Leiterplatten fallen,

. . .

für das Bestücken von Leiterplatten mit Chips nicht in Frage. Ebenfalls ungeeignet für diesen Zweck ist eine Vorrichtung zum lagerichtigen Aufsetzen von mit externen Anschlußstiften versehenen Bauelementen auf eine Leiterplatte (DE-AS 22 07 914), welche aus senkrecht stehenden Magazinen unter dem Einfluß der Schwerkraft auf die Leiterplatte fallen und dabei durch Rundstabpaare, die zwischen den Anschlußstiften hindurchgreifen, vereinzelt werden. Beim freien Fallen von extrem dünnen und leichten plättchenförmigen Bauelementen auf die Leiterplatte würden Lagetoleranzen entstehen, die bei miniaturisierten Schaltungen nicht tragbar sind.

Um solche Toleranzen auf ein zulässiges Maß zu verringern, ist eine Vorrichtung bekannt (DE-OS 27 16 330), bei welcher die gebündelten Magazine für die Bauelemente möglichst nahe an die bereits mit einem Klebstoffauftrag versehene Leiterplatte herangeführt werden und dann durch eine Schubeinrichtung aus jedem Magazin ein Bauelement heraus- und an die Leiterplatte angedrückt wird. Bei dieser Vorrichtung ist nicht auszuschließen, daß die Öffnungsränder der Magazine mit dem Klebstoffauftrag der Leiterplatte in Berührung kommen und verschmutzen. Außerdem ist die Länge der Magazine und damit die Anzahl der in den Magazinen stapelbaren Bauelemente begrenzt, weil davon auch die Ausbildung, der Platzbedarf und die Funktionssicherheit der Schubeinrichtung abhängt. Zur genauen Positionierung der Bauelemente sind innerhalb eines jeden Magazins zwei Blattfedern vorgesehen, welche das vorderste Bauelement an zwei im rechten Winkel aneinander stossende Innenwände des Magazins drücken. Diese Anordnung verteuert die Vorrichtung, erscheint störanfällig und erhöht den Platzbedarf für die Magazine, was dem Bestreben nach einem möglichst engen Raster für die in
einem Arbeitsgang gemeinsam auszubringenden Bauelemente zuwiderläuft.

Zum Erfassen auch extrem kleiner und dünner Chips und
Aufsetzen auf eine Leiterplatte ist es weiter bekannt,
die Chips mit Hilfe von Saugelementen aus den ebenfalls
zu einem Bündel zusammengefaßten Magazinen abzuheben
und zur Leiterplatte zu transportieren. Bei einer bekannten Vorrichtung dieser Art (DE-OS 29 15 366) ist
dazu eine mit einem Raster von Saugöffnungen versehene
Transferplatte vorgesehen, welche eine mit Unterdruck
versorgbare Kammer verschließt und zwischen zwei Endlagen hin- und hergehend angetrieben ist, von denen die
eine mit dem Magazinbündel und die andere mit der in
die Vorrichtung eingelegten Leiterplatte korrespondiert.
Diese Bewegung der Transferplatte ist kombiniert mit einer
Auf- und Abbewegung zum Absaugen der Bauelemente aus
den Magazinen und Aufsetzen auf die Leiterplatte, sodaß sich insgesamt ein relativ hoher Aufwand für den
Antrieb der Transferplatte ergibt. Trotzdem ist eine
exakte Positionierung der Bauelemente auf der Leiterplatte nicht gewährleistet, weil eine Vielzahl von
Toleranzen die Lage der Bauelemente beeinflußt und
Mittel zum genauen Postionieren der Bauelemente in
einem dem Aufsetzen auf die Leiterplatte vorgeschalteten, besonderen Arbeitsgang offenbar nicht angebracht
werden können. Außerdem kann auch bei dieser Vorrichtung nicht ganz ausgeschlossen werden, daß die Transferplatte mit dem Klebstoff auf der Leiterplatte in
Berührung kommt und verschmutzt bzw. den Klebstoff
auf die Öffnungsränder der Magazine überträgt, wonach
ein einwandfreies Arbeiten der Vorrichtung nicht mehr

...

gewährleistet ist. Ferner erscheint auch bei dieser
Vorrichtung eine gesteuerte Vorschubeinrichtung für
die magazinierten Bauelemente unerläßlich, wodurch die
Vorrichtung verteuert und das Fassungsvermögen der
Magazine eingeschränkt wird.

Bei einer anderen bekannten Vorrichtung (DE-OS 29 35 021)
werden die Bauelemente mit Hilfe von einzelnen Saugröhrchen auf die Leiterplatte aufgesetzt. Die vorliegende Erfindung geht gattungsmäßig von einer derartigen Vorrichtung aus. Eine solche Vorrichtung hat den
Vorteil, daß der die Bauelemente erfassende Mündungsbereich der Saugröhrchen durch auf der Leiterplatte
haftenden Klebstoff nicht verunreinigt werden kann.
Außerdem ist es möglich, in der Mündungsebene der Saugröhrchen eine in dieser Ebene verschiebbare, mit
Fenstern zur Aufnahme der Bauelemente versehene Positionierplatte vorzusehen, mit welcher die Bauelemente
vor dem Aufsetzen auf die Leiterplatte in zwei senkrecht aufeinanderstehenden Achsrichtungen positioniert
werden können. Bei der bekannten Vorrichtung werden
jedoch die Saugröhrchen auch zum Abheben der Bauelemente von den Magazinen benutzt, sodaß sie nicht nur
in Achsrichtung verschoben, sondern auch noch in einer
anderen Richtung bewegt bzw. um eine senkrecht zu
ihrer Längsachse angeordnete Achse gedreht werden müssen.
Die Saugröhrchen sind zu diesem Zweck gemeinsam an
einer Transferplatte befestigt, an welcher auch eine
Positionierplatte größerer Wandstärke in zwei senkrecht aufeinanderstehenden Richtungen verschiebbar gelagert ist, in deren Fenster die Enden der Saugröhrchen hineinragen. Diese Ausführung benötigt einen sehr
aufwendigen Antrieb. Trotzdem erscheint eine exakte
Positionierung der Bauelemente nicht immer gewährleistet,
weil die Endstellungen der Positionierplatte im Betrieb

...

doch von einer Vielzahl von Toleranzen beeinflußt werden können.

Vorteile der Erfindung

Die erfindungsgemäße Anordnung mit den kennzeichnenden Merkmalen des Hauptanspruchs hat demgegenüber den Vorteil, daß sich alle zum Transport der Bauelemente vorgesehenen Teile nur in einer Richtung hin- und herbewegen, sodaß ein wesentlich einfacheres Getriebe als bei der bekannten Vorrichtung benötigt wird und wegen der geringeren Anzahl von Bewegungsspielen im Antrieb die Positioniertoleranzen noch kleiner als bisher gehalten werden können. Außerdem können die Bauelemente vom Abheben aus den Magazinen bis zum Aufsetzen auf die Leiterplatte formschlüssig geführt werden, sodaß sich eine hohe Funktionssicherheit ergibt.

Die erfindungsgemäße Anordnung nach dem Hauptanspruch eröffnet ferner eine Reihe von Möglichkeiten, die Vorrichtung in Bezug auf Funktion und konstruktiven Aufbau vorteilhaft aus- und weiterzubilden. Durch die in den Unteransprüchen aufgeführten Maßnahmen sind derartige vorteilhafte Aus- und Weiterbildungen möglich.

Ein besonders einfacher Antrieb ergibt sich durch die Anordnung nach Anspruch 2, bei welcher u.a. die Magazine oberhalb der Schieberplatte angeordnet und die Bauelemente durch Schwerkraft gegen die Schieberplatte gedrückt sind. Dadurch entfallen gesteuerte Mittel zur Erzeugung einer auf die magazinierten Bauelemente einwirkenden Schubkraft und bei Festlegung des Fassungsvermögens der Magazine braucht auf solche Mittel keine Rücksicht genommen zu werden. Das Fassungsvermögen kann daher ohne Beeinträchtigung der Funktionssicherheit auf

...

mehrfaches der bekannten Magazine, beispielsweise auf 2000 bis 2500 Bauelemente, gesteigert werden. Die Magazine können verschieden lang sein und das Auswechseln der Magazine ist wegen des Fehlens von gesteuerten Mitteln zur Schubkrafterzeugung sehr einfach. Auch ist ein Magazinwechsel bei Teilfüllung grundsätzlich möglich.

Ferner hat die Magazinanordnung nach Anspruch 2 den Vorteil, daß die magazinierten Bauelemente keiner dynamischen Druckwechselbelastung ausgesetzt sind, sodaß auch die Gefahr des Brechens der empfindlichen keramischen Bauelemente erheblich verringert ist. Wenn dieser Fall jedoch trotzdem einmal eintritt, wird die Ausgangsöffnung bzw. das Innere der Magazine nicht verstopft, weil auch kleinste Bruckpartikel durch Schwerkraft aus dem Magazin herausfallen. Bei der bekannten Anordnung mit von unten her nachgeschobenen Bauelementen kann es vorkommen, daß die Bruckpartikel das Führungsspiel der Bauelemente in den Magazinen zusetzen und zu Betriebsstörungen führen.

Wenn die Vorrichtung zum Bestücken von Leiterplatten mit rechteckigen bzw. quadratischen Bauelementen dient und die Schieberplatte gemäß den Merkmalen des Anspruchs 3 ausgebildet und geführt bzw. angetrieben ist, werden eine besondere Platte zum exakten Positionieren der Bauelemente gegenüber der Leiterplatte und Mittel zum zusätzlichen Verschieben dieser Platte eingespart. Der Verschiebeweg kann vorteilhaft mit Rücksicht auf die in Verschieberichtung gemessene Größentoleranz der Bauelemente so bemessen sein, daß sich eine Aufsetz- bzw. Positioniergenauigkeit von etwa 50 % dieser Toleranz in beiden Richtungen ergibt.

...

- 7 -

Ein besonders gedrängter Aufbau der Vorrichtung ergibt
sich, wenn gemäß Anspruch 4 die Saugröhrchen zwischen
den Magazinen angeordnet sind und der Verschiebeweg
der Schieberplatte kleiner als die Rasterteilung
der Magazine in Verschieberichtung ist. Dadurch ergibt sich ein extrem kurzer Verschiebeweg von den Magazinen zu den Saugröhrchen, wodurch sich außer dem
Platzbedarf auch die Taktzeit der Vorrichtung erheblich verringern läßt. Bei einem praktischen Ausführungsbeispiel beträgt die Taktzeit 6 Sekunden, sodaß sich
selbst bei einer etwa notwendig werdenden Mehrfachanordnung von gleichartigen Vorrichtungen zur Bestükkung von Leiterplatten mit besonders kleinem Layout-
Raster insgesamt eine Zeit- und Kostenersparnis gegenüber den bekannten Vorrichtungen und Verfahren ergibt.

Der Zusammenbau der Vorrichtung wird vereinfacht, wenn
die Magazine und Saugröhrchen gemäß Anspruch 5 reihenweise aufeinanderfolgend angeordnet sind. In diesem
Fall kann eine die Magazine enthaltende Baugruppe
seitlich in eine die Saugröhrchen enthaltende Baugruppe eingeschoben und danach am Gestell der Vorrichtung
befestigt werden.

Zur Beschwerung der Bauelemente in den Magazinen kann
vorteilhaft in jedem Magazin ein Gewichtskörper vorgesehen sein. Dieser kann zweckmäßig im Magazin innen geführt sein, sodaß er die Bauelemente genau zentrisch
und daher klemmfrei belastet.

Der Einbau der Magazine in die Vorrichtung kann erleichtert werden, wenn jedes von ihnen mit einer gemäß Anspruch 7 ausgebildeten Schiebeführung für einen
Verschlußstopfen aufgebildet ist. In diesem Fall können alle Verschlußstopfen durch ein vom Antrieb für die

...

Schieberplatte bewegtes Element in einem gemeinsamen
Arbeitsgang von den Magazinen entfernt werden.

Dieses Element kann beispielsweise eine zusätzliche
Platte sein, welche auf die Schieberplatte aufsteckbar ist und hochstehende Lappen zum Erfassen der Verschlußstopfen hat. Nach dem Ausstoßen der Verschlußstopfen aus den Schiebeführungen der Magazine ist eine
solche Platte wieder von der Schieberplatte zu entfernen, wonach die Vorrichtung betriebsbereit ist.

Besonders vorteilhaft ist es jedoch, wenn die Verschlußstopfen gemäß Anspruch 8 ausgebildet sind. In
diesem Fall können die Verschlußstopfen durch die
Schieberplatte selbst entfernt werden, sodaß das
Anbringen und Wegnehmen einer zusätzlichen Platte
entfällt. Zu beachten ist dabei, daß sich beim Einbau der Magazine die Schieberplatte in einer Stellung befindet, in welcher ihre Fenster mit den
Magazinen korrespondieren.

Bei Betriebsstörungen oder -unterbrechungen kann es auch
erwünscht sein, mehrere oder alle Magazine gleichzeitig zu verschließen. Bei der erfindungsgemäßen Anordnung ist auch dieser Arbeitsgang mit Hilfe der
Schieberplatte möglich. Hierfür ist es zweckmäßig,
daß die Verschlußstopfen gemäß Anspruch 10 stirnseitig mit Rampenflächen versehen sind, welche beim
Einschieben der Verschlußstopfen in die Schiebeführrungen der Magazine die Bauelemente in den Magazinen
nach oben anheben.

Zur Belüftung der Magazine wird vorgeschlagen, daß die
Magazine an mindestens einer Seitenwand einen Längsschlitz haben.

...

Zur Schonung der Bauelemente und Verminderung der Bruchgefahr wird gemäß Anspruch 12 vorgeschlagen, daß die
Mündungen der Saugröhrchen von elastisch verformbaren
Kragen umgeben sind. Diese können gemäß Anspruch 13
vorteilhaft durch auf die Saugröhrchen aufgeschobene
und über deren Stirnende vorstehende flexible Schläuche gebildet sein. Dadurch werden auf einfache und
betriebssichere Art und Weise die Höhentoleranzen der
Bauelemente und der Leiterplatte ausgeglichen und
ein gleichmäßiger Anpreßdruck erzielt.


Zeichnung


Ein Ausführungsbeispiel der Erfindung ist in der Zeichnung dargestellt und in der nachfolgenden Beschreibung
näher erläutert. Es zeigen


Figur 1 in schematischer Darstellung die erfindungswesentlichen Teile der Vorrichtung teils in
Seitenansicht und teils im Schnitt,


Figur 2 eine Draufsicht auf die Vorrichtungsteile
nach Figur 1,


Figur 3 in stark vergrößertem Maßstab einen Längsschnitt durch ein Einzelmagazin der Vorrichtung nach den Figuren 1 und 2,


Figur 4 einen Schnitt nach der Linie IV - IV in
Figur 3,


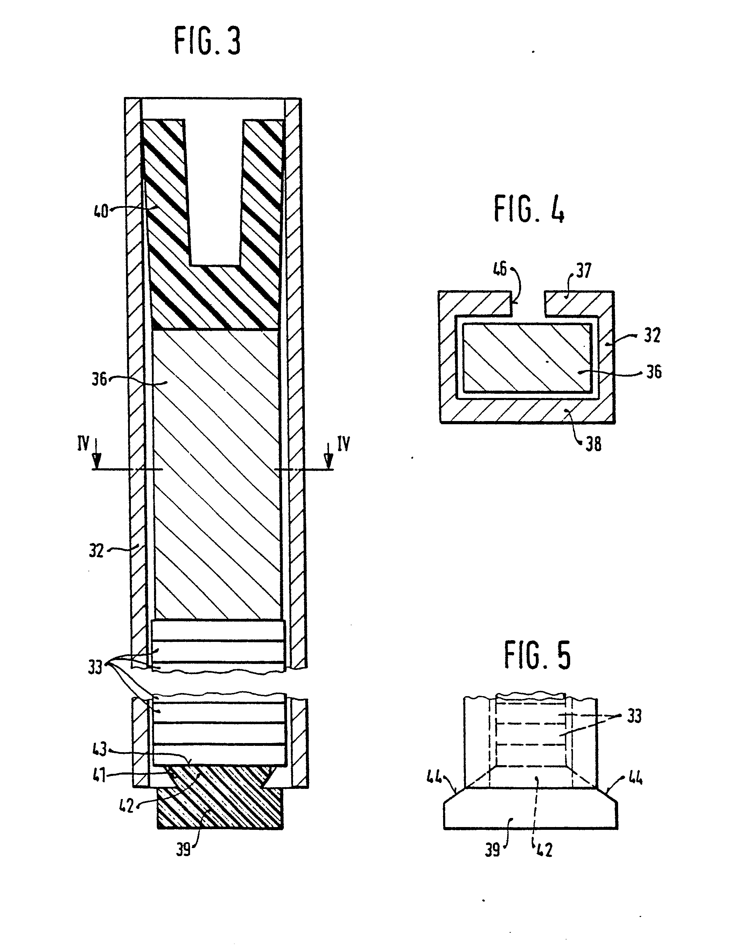

Figur 5 einen Teil des Einzelmagazins nach Figur 4
in Seitenansicht,


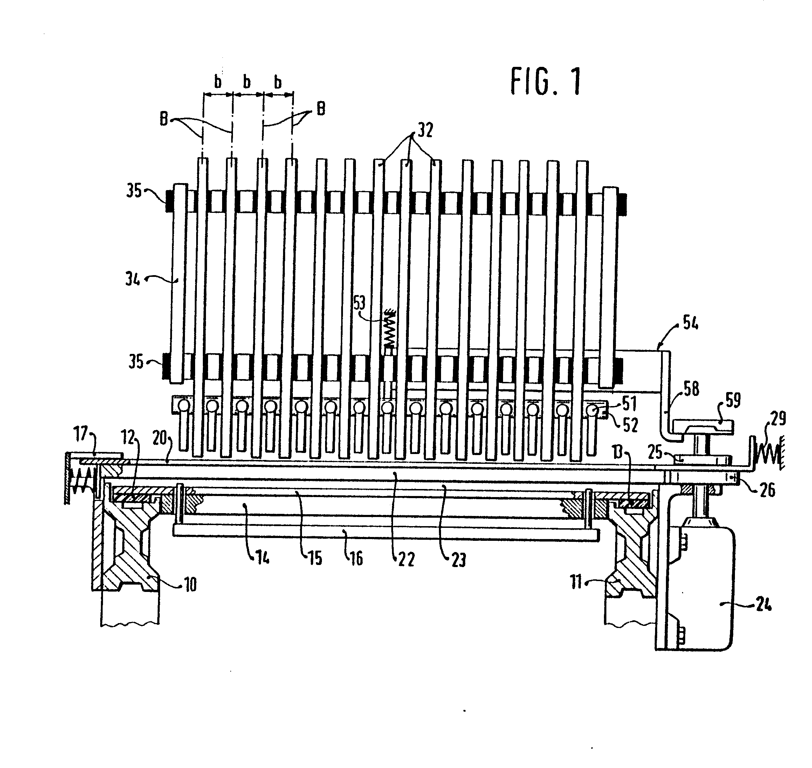

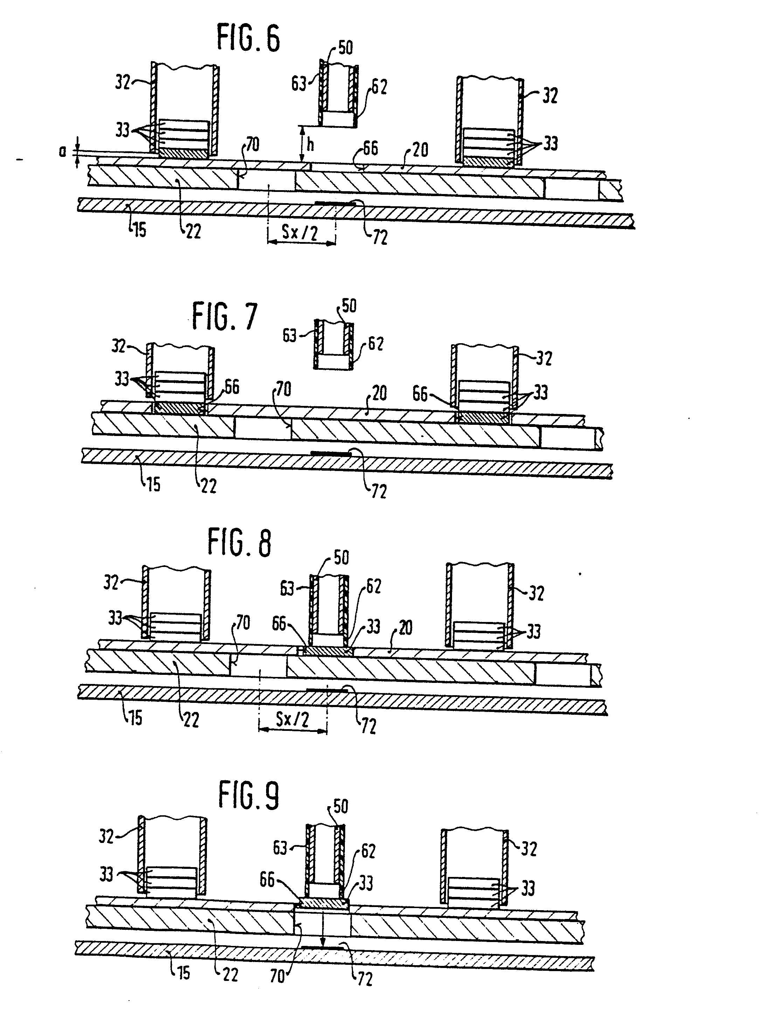

Figuren 6 bis 9 in gegenüber Figur 1 vergrößerter
Darstellung Teile der Vorrichtung in der
Grundstellung und in verschiedenen Arbeitsstellungen,


...

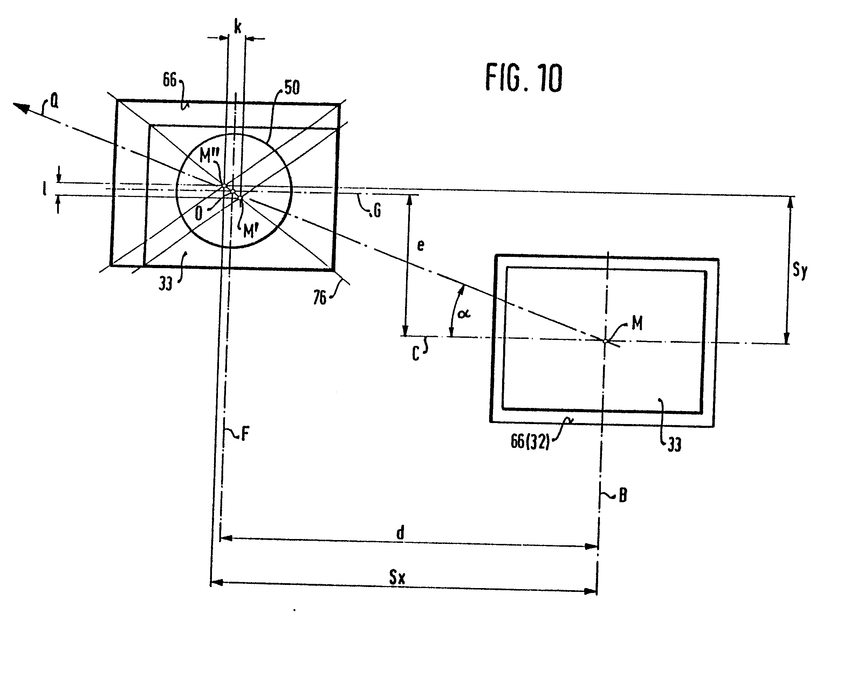

Figur 10 ein Schaubild zur Erklärung der Lagetoleranzen, welche die Bauelemente gegenüber
    der Leiterplatte haben können.


Beschreibung des Ausführungsbeispiels

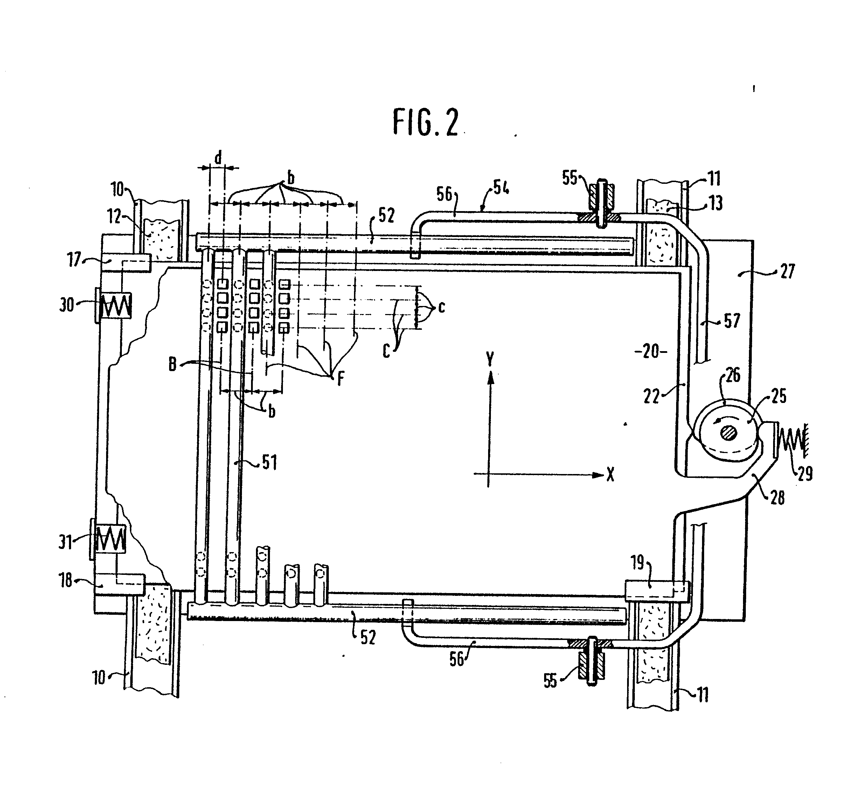

Die Vorrichtung ist Teil einer Montagestraße, in welcher die Leiterplatten zunächst mit Klebstoffaufträgen
an den betreffenden Stellen versehen und dann mit
kleinen, rechteckigen Bauelementen (Chips) bestückt
werden. Zum Transport der Leiterplatten ist ein
Doppelgurtförderer vorgesehen. In den Figuren 1 und
2 sind dessen beide Längsträger 10 und 11 und die
beiden Fördergurte 12 und 13 sichtbar. Die Vorrichtung hat zwischen den Längsträgern 10, 11 einen
Support 14 und nicht dargestellte Mittel, welche
eine in der Vorrichtung angekommene Leiterplatte 15
gegenüber den weiterlaufenden Fördergurten 12, 13
anhalten. Der Einfachheit halber liegt in der Zeichnung die Leiterplatte 15 unmittelbar auf den Fördergurten 12, 13 auf. In der Praxis werden die Leiterplatten auf Werkstückträgern transportiert, die
ihrerseits auf den Fördergurten 12, 13 aufliegen und
in der Vorrichtung auf den Support 14 auflaufen. Am
Support 14 ist eine Indexiervorrichtung 16 angeordnet,
welche eine angehaltene Leiterplatte 15 gegenüber den
gestellfesten Teilen der Vorrichtung in einem in Supportebene liegenden, zweiachsigen Koordinatensystem
X-Y (Figur 2) genau ausrichtet. Die Koordinaten X und
Y verlaufen genau parallel zu den Rasterlinien des
Layouts auf der indexierten Leiterplatte 15.

Über dem Support 14 ist die Vorrichtung mit gestellfesten waagrechten Führungen 17, 18, 19 versehen, in
welchen eine Schieberplatte 20 und unmittelbar darunterliegend eine Blendenplatte 22 quer zur Laufrichtung der Fördergurte 12, 13 verschiebbar gelagert
sind. Die Führungen 17, 18, 19 sind in einem solchen
Abstand über dem Support 14 angeordnet, daß zwischen
der Unterseite der Blendenplatte 22 und der Oberseite
einer Leiterplatte 15 ein freier Raum 23 verbleibt. Die
Führungen 17, 18, 19 schließen mit der Koordinate X
der Indixiereinrichtung 16 einen kleinen, in der Figur
2 nicht erkennbaren Winkel $\alpha$ (Figur 10) ein. Der
Zweck dieser Schrägstellung der Führungen 17, 18, 19
ist später anhand der Figur 10 erklärt.

Die Schieberplatte 20 und die Blendenplatte 22 sind gemeinsam von einem Elektromotor 24 über Nockenscheiben
25 und 26 angetrieben. Der Elektromotor 24 ist über
eine Konsole 27 an dem einen Längsträger 11 des Gurtförderers befestigt. Bei ausgeschalteter Vorrichtung
sind die beiden Nockenscheiben 25, 26 in die in Figur
2 gezeigte Stellung überführt, in welcher die beiden
Platten 20, 22 die eine Endstellung ihres Bewegungsbereiches erreicht haben. Diese Endstellung ist nachstehend aus Gründen einer möglichst verständlichen
Funktionsbeschreibung aus der Sicht der Figur 2 als
linke Endstellung bezeichnet. Bei laufendem Elektromotor 24 werden die Nockenscheiben 25, 26 in Richtung des eingezeichneten Pfeils gedreht.

Beim Anlaufen des Elektromotors 24 wird zunächst die
Schieberplatte 20 über einen an ihr befestigten Winkelarm 28 nach rechts in eine rechte Endstellung verschoben, in welcher sie über einige Drehwinkelgrade der
Nockenscheibe 25 verbleibt. Am Winkelarm 28 greift eine
Druckfeder 29 an, welche den Winkelarm 28 an der Nokkenscheibe 25 angelegt hält und die Schieberplatte 20
bei Weiterdrehung der Nockenscheibe 25 in die dargestellte linke Endstellung überführt. Die Nockenscheibe 25 hat dann einen Drehwinkel von etwa 90$^\circ$ zu-

rückgelegt. Die Verschiebewege $s_x$ und $s_y$ (Figur 10)
der Schieberplatte 20 in Richtung der X-Koordinate
und der Y-Koordinate werden später anhand der Figur
10 noch näher erläutert.

Die Blendenplatte 22 wird nach einer Drehung der Nockenscheibe 26 von etwa 180° von Druckfedern 30, 31 aus der
dargestellten linken Endstellung nach rechts in eine
rechte Endstellung verschoben, in welcher sie über einen
Drehwinkel der Nockenscheibe 26 etwa 90° verbleibt. Danach wird die Blendenplatte 22 durch die Nockenscheibe
26 zwangsläufig in die gezeigte linke Endstellung zurückgeführt. Die Verschiebewege der Blendenplatte 22
in Richtung der X- und der Y-Koordinate entsprechen
etwa dem halben Wert der Verschiebewege $s_x$ und $s_y$ der
Schieberplatte 20. Diese beiden Verschiebewege entsprechen etwa der Rasterteilung des Layouts der Leiterplatte.15.

Über der Schieberplatte 20 ist ein Bündel von röhrchenförmigen Magazinen 32 zur Aufnahme von rechteckförmigen
Bauelementen 33 (Figur 3) vorgesehen. Die Magazine 32
sind in einem Gestell 34, welches zwei waagrechte Gitterrahmen 35 hat, einzeln auswechselbar befestigt. Die
unteren Stirnseiten der Magazine 32 sind um einen Abstand a (Figur 6) von der Schieberplatte 20 entfernt,
der kleiner als die Dicke der einzelnen Bauelemente 33
ist. Das Raster der Magazine 32 entspricht ebenfalls
dem Layout der zu bestückenden Leiterplatten, wobei
die in X-Richtung gemessenen Rasterabstände b das doppelte des kleinstmöglichen Bauelementeabstands auf
dem Layout und die in Y-Richtung gemessenen Raster-

...

abstände c den kleinstmöglichen Bauelementeabstand entsprechen. Die in X-Richtung verlaufenden Rasterlinien
C und die senkrecht dazu verlaufenden Rasterlinien B
der Magazine 32 sind genau parallel zu den entsprechenden Rasterlinien einer indexierten Leiterplatte 15
ausgerichtet. Das gesamte Bündel der Magazine 32 ist
gegenüber dem Bestückungsfeld einer indexierten Leiterplatte 15 aus der Sicht der Figur 2 in X-Richtung um
das Maß d (Figuren 2 und 10) nach rechts und in Y-Richtung um ein inFigur 2 nicht sichtbares Maß e (Figur 10)
nach unten verschoben. Die Größen der Maße d und e werden
später anhand der Figur 10 erklärt.

Die Bauelemente 33 sind in den Magazinen 32 einzeln übereinanderliegend gestapelt und werden durch die Schwerkraft sowie durch einen Gewichtkörper 36 nach unten gegen
die Schieberplatte 20 gedrückt. Die Magazine 32 sind im
Querschnitt der Gestalt der Bauelemente 33 angepaßt und
so bemessen, daß auch die Bauelemente mit größter Plustoleranz noch mit geringem Bewegungsspiel in den Magazinen 32 verschiebbar sind. Die breiteren Seitenwände
37, 38 (Figur 4) der Magazine 32 sind genau in X-Richtung gestellt. Die gefüllten Magazine 32 sind vor ihrem
Einbau in die Vorrichtung unten durch einen Stopfen 39
und oben durch einen Klemmkörper 40 verschlossen.

Der Stopfen 39 ist von der Seite her in den unteren
Stirnrand des betreffenden Magazins 32 eingeschoben. Zu
diesem Zweck sind dessen Seitenwände 37, 38 in den Stirnrändern mit schwalbenschwanzförmigen Vertiefungen 41
versehen, in welche ein entsprechend geformter Ansatz
42 des Stopfens 39 passend eingreift. Der übrige Teil
des Stopfens 39 steht über die Stirnseite des Magazins
32 nach unten hervor und hat ein der Gestalt der Bau-

...

elemente 33 entsprechendes Querschnittsprofil. In Einschieberichtung gesehen ist der Stopfen 39 vorn und hinten mit je einer zu seiner Kopfseite 43 hin ansteigenden Rampe 44 versehen. Die beschriebene Lagerung und Ausbildung des Stopfens 39 hat den Vorteil, daß - wie noch näher beschrieben - die Stopfen aller in die Vorrichtung eingesetzten Magazine 32 am Arbeitsbeginn durch Vorrichtungsteile maschinell entfernt werden können.

Der Klemmkörper 40 ist so ausgebildet, daß er durch Reibung in der eingesetzten Stellung festgehalten bleibt. Zur Belüftung der magazinierten Bauelemente 33 und zum Druckausgleich des im Betrieb fortschreitend größer werdenden Leerraumes innerhalb eines Magazins 32 ist jedes von ihnen in der Seitenwand 37 mit einem Längsschlitz 46 versehen. Die Magazine 32 sind so lang ausgeführt, daß sie bis zu 2500 Bauelemente 33 aufnehmen können.

Zwischen den Magazinen 32 ist ein Bündel von Saugröhrchen 50 angeordnet, welches das gleiche Raster und die gleiche Anzahl von Elementen wie das Bündel der Magazine 32 hat, jedoch exakt über den Bestückungsplätzen einer indexierten Leiterplatte 15 steht. Daraus ergibt sich, daß die in Y-Richtung verlaufenden Rasterlinien F der Saugröhrchen 50 gegenüber den Rasterlinien B der Magazine 32 um das Maß d nach links (Figur 2) und die in X-Richtung verlaufenden Rasterlinien G (Figur 10) der Saugröhrchen 50 gegenüber den Rasterlinien C der Magazine 32 das in Figur 2 nicht mehr erkennbare Maß e nach oben verschoben sind. Die Saugröhrchen 50 sind auf den Rasterlinien F reihenweise an waagrechtliegenden, sich zwischen den Reihen der Magazine 32 erstreckenden Zuführungsrohren 51 befestigt, die an den Enden an je ein Sammelrohr 52 ange-

...

schlossen sind. Die Zuführungsrohre 51 und die Sammelrohre 52 bilden einen starren Rahmen, welcher über nicht
dargestellte Mittel in senkrechter Richtung parallelverschieblich geführt und durch Federn 53 nach unten gedrückt
ist. Die beiden Sammelrohre 52 sind über flexible Leitungen an eine ebenfalls nicht dargestellte Unterdruckquelle angeschlossen. Diese ist in einer Taktfolge gesteuert, welche anhand der Figuren 6 bis 9 noch näher erläutert wird.

Der aus den Rohren 51 und 52 gebildete Rahmen läßt sich
mit Hilfe einer Wippe 54 entgegen der Kraft der Federn 53
nach oben verschieben. Die Wippe 54 ist um die gemeinsame Achse von zwei sich gegenüberliegenden Lagern 55
schwenkbar und hat zwei Hebelarme 56, die über einen
Steg 57 miteinander verbunden sind. Die freien Enden
der Hebelarme 56 fassen unter die Sammelrohre 52 und
tragen außerdem die Lagerzapfen, deren Abstand zum
Steg 57 kleiner als zu den freien Enden ist. Der Steg
57 ist oberhalb des Elektromotors 24 mit einem nach
unten vorstehenden Ansatz 58 (Figur 1) versehen, welcher unter dem Einfluß der Federn 53 an einer axialen
Nockenscheibe 59 auf der Abtriebswelle des Elektromotors
24 anliegt. Bei laufendem Elektromotor 24 wird über die
axiale Nockenscheibe 59 und die Federn 53 das Bündel der
Saugröhrchen 50 auf und abbewegt. Der Bewegungsablauf
wird anhand der Figuren 6 bis 9 noch näher erklärt.

Ein jedes Saugröhrchen 50 ist an seiner Mündung mit
einem elastischen Kragen 62 (Figur 6) versehen, der
durch das überstehende Ende eines auf das Saugröhrchen 50 aufgeschobenen Kunststoffschlauches 63 gebildet ist. Der Außendurchmesser des Kragens 62 ist etwas kleiner als die Breite der Bauelemente 33. In der in Figur 6 dargestellten Grundstellung des Saugröhrchens 50 sind die freien Stirnränder der Kragen 62 um den Abstand h von der Schieberplatte 20 entfernt, welcher etwas größer als der Abstand a der Magazine 32 von der Schieberplatte 20 gewählt ist.

Die Schieberplatte 20 ist mit einem Raster von rechteckigen Fenstern 66 (Figur 6) versehen, welches genau dem Raster der Magazine 32 und der Saugröhrchen 50 entspricht und in der in Figur 2 dargestellten linken Endstellung der Schieberplatte 20 unter dem Raster der Saugröhrchen 50 steht. Die Form und Ausrichtung der Fenster 66 entspricht der Form und Ausrichtung der Bauelemente 33, wobei jedoch die Fenster 66 so bemessen sind, daß auch die Bauelemente 33 mit der größten Plustoleranz noch ungehindert in das entsprechende Fenster fallen können. Wenn der Elektromotor 24 die Schieberplatte 20 aus der in Figur 2 dargestellten linken Entstellung in die rechte Endstellung überführt hat, liegen die Fenster 66 exakt unter den Mündungen der Magazine 32, wie in den Figuren 7 und gezeigt ist.

Die Blendenplatte 22 ist mit einem gleichartigen Raster von rechteckförmigen Fenstern 70 versehen, welche ein etwas größeres lichtes Profil als die Fenster 66 in der Schieberplatte 20 haben. In der in den Figuren 6 und 8 gezeichneten Stellung der Blendenplatte 22 sind die Fenster 70 in X-Richtung um das Maß $s_x/2$ gegenüber den Fenstern 66 versetzt. In der rechten Endstellung der Blendenplatte 22, die in Figur 9 dar-

...

gestellt ist, liegen deren Fenster 70 mit hinreichender Genauigkeit unter den Saugröhrchen 50 und über den Bestückungsplätzen der indexierten Leiterplatte 15.

Die beschriebene Vorrichtung arbeitet wie folgt:

Es sei angenommen, daß eine bereits mit Klebstoffaufträgen 72 (Figur 6) versehene Leiterplatte 15 gerade in der Vorrichtung angekommen und durch die Indexiereinrichtung 16 in die richtige Lage gebracht worden ist. Ferner sei vorausgesetzt, daß die eingebauten Magazine 32 mit Bauelementen 33 gefüllt sind, die Verschlußstopfen 39 bereits von den Magazinen 32 entfernt sind und daß die zum Transportieren der Bauelemente 33 vorgesehenen Teile der Vorrichtung die in Figur 6 dargestellte Lage einnehmen. Wenn jetzt der Elektromotor 24 eingeschaltet und die Steuerung für die Vakuumquelle aktiviert wird, läuft folgendes Programm ab:

Die untersten, in der Zeichnung zur Unterscheidung schraffierten Bauelemente 33 der Magazine 32 liegen auf der Oberseite der Schieberplatte 20 auf. Die Schieberplatte 20 wird unmittelbar nach dem Anlaufen des Elektromotors 24 durch die Nockenscheibe 25 nach rechts in die in Figur 7 gezeigte rechte Endstellung bewegt. In dieser korrespondieren die Fenster 66 in der Schieberplatte 20 mit den Magazinen 32, sodaß die schraffierten untersten Bauelemente 33 aus den Magazinen 32 in die Fenster 66 fallen und die anderen gestapelten Bauelemente nachrücken. Die Blendenplatte 22 deckt die Fenster 66 nach unten ab und verhindert, daß die schraffierten Bauelemente 33 durch die Fenster

...

66 hindurchfallen. Bei Weiterdrehung der Nockenscheibe
25 drückt die Feder 29 die Schieberplatte 20 nach
links in die linke Endstellung zurück, sodaß die in den
Fenstern 66 liegenden Bauelemente 33 unter die Saugröhrchen 50 zu liegen kommen. Die Schieberplatte
20 deckt in dieser Stellung die Magazine 32 wieder ab.
Die Blendenplatte 22 hat sich während dieser ersten
Teilvorgänge des Bauelemententransportes noch nicht
bewegt.

Wenn sich die Axialnockenscheibe 59 um etwa 90° gedreht
hat, gibt sie die Wippe 54 soweit frei, daß die Federn
53 den Rahmen 51, 52 mindestens bis zum satten Aufsetzen der Saugröhrchen 50 auf die Bauelemente 33 nach
unten drücken können (Figur 8). Die elastischen Kragen
62 verhindert dabei ein Beschädigen der Bauelemente 33
durch zu hartes Aufsetzen und stellen sicher, daß das
Innere der Saugröhrchen 50 spaltfrei abgedichtet wird.
Nun werden die Vakuumquelle aktiviert und durch Weiterdrehen der Axialnockenscheibe 59 die Bauelemente 33 in
die Stellung nach Figur 9 angehoben.

Die Stellung der Saugröhrchen 50 nach Figur 9 ist erreicht, wenn sich die Motorantriebswelle um etwa 180°
gedreht hat. Beim Weiterdrehen gibt die Nockenscheibe
26 die Blendenplatte 22 frei, welche nun durch die Federn 30, 31 nach rechts in die in Figur 9 dargestellte
rechte Enstellung verschoben wird. Danach wird das
Bündel der Saugröhrchen 50 erneut und diesmal soweit
freigegeben, daß die Saugröhrchen 50 die Bauelemente 33 satt auf die Klebstoffaufträge 72 der
Leiterplatte 15 aufdrücken können. Danach werden in

...

gesteuerter Folge die Vakuumquelle abgeschaltet und
die Saugröhrchen 50, die Blendenplatte 22 und die
Schieberplatte 20 in die in den Figuren 2 und 6 gezeigte Stellung zurückgeführt. Nun können, gegebenenfalls nach einem Aushärtevorgang der Klebstoffaufträge
72, die bestückte Leiterplatte 15 weitertransportiert
und eine neue Leiterplatte in die Vorrichtung eingeführt
werden. Wenn das Layout der Leiterplatte 15 auch in
X-Richtung eine Bestückung im Rastermaß c bzw. b/2
vorsieht, werden die Leiterplatten in einer weiteren
Vorrichtung, welche eine entsprechend geänderte Indexierung hat, einem weiteren Bestückungsvorgang unterzogen.

Bei der bisherigen Beschreibung der Arbeitsabläufe
ist die genaue Positionierung der Schieberplatte 20
gegenüber den Saugröhrchen 50 in ihrer linken Endstellung (Figuren 2, 6, 8 und 9) außer Acht gelassen.
Im folgenden wird die genaue Positionierung anhand der
Figur 10 im einzelnen erläutert.

Ein völlig exaktes, von den Größentoleranzen der Bauelemente 33 unabhängiges Positionieren der Bauelemente auf der Leiterplatte 15 wäre theoretisch nur
möglich, wenn die Bauelemente in den Fenstern 66
der Schieberplatte 20 genau zentriert werden könnten. Dies bereitet jedoch in der Praxis große
Schwierigkeiten, weil bei allen denkbaren Lösungen
nicht sichergestellt ist, daß die Bauelemente in
den Fenstern  genau waagrecht liegen und sich die
Saugröhrchen 50 spaltfrei an die Bauelemente anlegen. Die vorliegende Erfindung macht von der an
sich bekannten Maßnahme Gebrauch, die Schieberplatte
20 in einem Winkel $\alpha$ zu dem durch die Seitenkanten
der Fenster 66 vorgegebenen Koordinatensystem zu bewegen. Das hat zur Folge, daß beim Bewegen der Schie-

...

berplatte 20 von der rechten in die linke Endstellung,
Pfeil Q in Figur 10, sich ein jedes Bauelement 33 unabhängig von seinen Größentoleranzen an zwei Seitenkanten des Fensters anlegt. In der linken Endstellung liegt dann der Mittelpunkt M des Bauelements unabhängig von dessen Größentoleranzen auf einer Diagonale 76 des Fensters 66, welche - bei exakter Lage
des Fensters 66 - die Achse 0 des Saugröhrchens 50
schneidet. Die Lage des Mittelpunktes M auf der Diagonale 76 wird durch die Toleranzabweichung des Bauelementes bestimmt. Es sei angenommen, daß das in
Figur 10 dargestellte Bauelement 33 ein solches mit
der größten Minustoleranz ist und daß das Bauelement
mit der größten Plustoleranz in etwa der Größe des Fensters 66 entspricht. Die Mittelpunkte M' und M" von
zwei derartigen, sich extrem unterscheidenden Bauelementen würden dann in X-Richtung um das Maß k und in
Y-Richtung um das Maß l auseinanderliegen. der Verschiebeweg der Schieberplatte 20 ist nun erfindungsgemäß so gewählt, daß beide Mittelpunkte M' und M" symmetrisch zur Achse 0 des Saugröhrchens 50 liegen, sodaß
die Toleranzabweichungen der Bauelemente-Positionierung
auf der Leiterplatte 15 etwa dem halben Wert der Größentoleranzen der Bauelemente in beiden Richtungen entspricht. Der Verschiebeweg der Schieberplatte 20 errechnet sich demnach aus den Rasterlinienabständen d
und e zwischen dem Bündel der Magazine 32 und dem der
Saugröhrchen 50, zuzüglich dem halben Wert von k bzw.
l.

In der Beschreibungseinleitung ist bereits darauf hingewiesen, daß bei Inbetriebnahme der Vorrichtung die
zunächst durch die Stopfen 39 verschlossenen Magazine
32 maschinell geöffnet werden können. Dabei werden durch
einen gesteuerten Einschaltimpuls die Schieberplatte 20

...

und die Blendenplatte 22 in die in Figur 7 gezeigte
Stellung gebracht, wonach die vollen Magazine 32
von oben her in das Gestell 34 eingeschoben werden,
bis die Stopfen 39 in die Fenster 66 treten und sich
auf der Blendenplatte 22 auflegen. Dadurch ist auch
sichergestellt, daß alle Magazine 32 die gleiche und
richtige Höhenlage einnehmen, in welcher ihre untere
Stirnseite den Abstand a zur Oberseite der Schieberplatte
20 hat. Sodann werden die Magazine 32 über nicht dargestellte Mittel im Gestell 34 der Vorrichtung festgespannt. Zum Auffangen der Stopfen 39 wird nun anstelle
einer Leiterplatte 15 eine Schale oder dergleichen in
den freien Raum 23 über dem Support 14 eingeführt. Danach wird der Elektromotor 24 eingeschaltet und die
Vakuumquelle aktiviert, worauf die Stopfen 39 aus den
Magazinen auf die gleiche Weise wie im Betrieb die Bauelemente 33 aus den Magazinen 32 heraus - unter die
Saugröhrchen 50 geschoben und von diesen dann in die
Schale abgelegt werden.

Wenn die Schale selbst ein entsprechendes Raster mit
Löchern zur Aufnahme der Stopfen hat, lassen sich umgekehrt die Magazine 32 auch maschinell wieder schließen.
Dabei werden zunächst die Stopfen 39 durch die Saugröhrchen 50 heraus- und in die Ebene der Schieberplatte
20 angehoben, welche sie dann seitlich in die Magazine
32 hinein verschiebt. Dabei heben die in Schieberichtung vorne liegenden Rampen 44 (Figur 5) der Stopfen
39 die Bauelementestapel in den Magazinen 32 nach oben
aus, sodaß die Stopfen 39 ungehindert in Verschlußstellung gelangen können.

R.
29.10.1981 Ki/Pi

ROBERT BOSCH GMBH, 7000 STUTTGART 1

Ansprüche

1. Vorrichtung zum Bestücken von Leiterplatten mit plättchenförmigen elektronischen Bauelementen, mit einem Bündel von senkrecht stehenden Magazinen, in denen die Bauelemente einzeln übereinanderliegend stapelbar sind, deren gegenseitige Zuordnung der vorgesehenen Anordnung der Bauelemente auf der Leiterplatte entspricht und deren Ausgangsöffnungen vorzugsweise in einer gemeinsamen Ebene liegen, ferner mit einem Support mit Lageindexierung für die zu bestückenden Leiterplatten und mit einer Transporteinrichtung zum gleichzeitigen Abnehmen aller in einem Arbeitsgang aufzubringender Bauelemente von den Ausgangsöffnungen der Magazine und zum Überführen der Bauelemente in eine mit deren vorgeschriebener Lage auf der Leiterplatte korrespondierenden, mit Abstand vor der Leiterplatte liegenden Stellung, von wo ein jedes Bauelement mit Hilfe eines zugeordneten Saugröhrchens an die Leiterplatte herangeführt und auf diese aufgesetzt wird, gekennzeichnet durch folg-

...

gende Merkmale:

a)   Die Transporteinrichtung hat eine mit Fenstern
     (66) zur Aufnahme der Bauelemente (33) versehene
     Schieberplatte (20), die in einer vorzugsweise
     unmittelbar vor den Ausgangsöffnungen der Magazine (32) liegenden Bewegungsebene zwischen einer
     ersten und einer zweiten Endstellung hin- und
     hergehend angetrieben ist;

b)   die Fenster (66) sind so verteilt und positioniert
     auf der Schieberplatte (20) angeordnet, daß sie
     in der ersten Endstellung der Schieberplatte (20)
     mit den Ausgangsöffnungen der Magazine (32) korrespondieren;

c)   in der ersten Endstellung der Schieberplatte (20)
     ist eine Schubkraft auf die magazinierten Bauelemente (33) wirksam, welche in jedes zu bestückende Fenster (66) der Schieberplatte (20)
     ein Bauelement (33) drückt;

d)   der Support (14) für die Leiterplatte (15) ist
     im Abstand zur Bewegungsebene der Schieberplatte
     (20) und mindestens annähernd parallel dazu so
     angeordnet, daß in der zweiten Endstellung der
     Schieberplatte (20) deren Fenster (66) mit der
     vorgesehenen Lage der Bauelemente (33) auf der
     am Support (14) indexierten Leiterplatte (15)
     korrespondieren;

e)   beim Bewegen der Schieberplatte (20) von der ersten in die zweite Endstellung sind Haltemittel
     (22) wirksam, die ein Herausfallen der Bauelemente
     (33) aus den Fenstern (66) der Schieberplatte (20)
     verhindern;

f) die Saugröhrchen (50) zum Aufsetzen der Bauelemente (33) auf die Leiterplatte (15) sind baulich getrennt von der Schieberplatte (20) ausgeführt und mindestens annähernd im rechten Winkel zur Schieberplatte (20) auf deren vom Support (14) für die Leiterplatte (15) abgekehrten Seite in Richtung ihrer Achsen verschiebbar gelagert;

g) die Saugröhrchen (50) sind abgestimmt mit den Bewegungen der Schieberplatte (20) so angetrieben, daß ihre Mündungen (62) an den Bauelementen (33) in den Fenstern (66) der Schieberplatte (20) zur Anlage kommen, wenn sich diese in ihrer zweiten Endstellung befindet.

2. Vorrichtung nach Anspruch 1, gekennzeichnet durch folgende Merkmale:

h) die Schieberplatte (2o) ist in einer waagrechten Ebene verschiebbar gelagert;

i) die Magazine (32) sind oberhalb der Schieberplatte (20) angeordnet und die darin gestapelten Bauelemente (33) sind durch Schwerkraft gegen die Schieberplatte (20) gedrückt;

j) Zum Verhindern des Herausfallens der in der ersten Endstellung der Schieberplatte (20) in deren Fenster (66) eingetretenen Bauelemente (33) ist unterhalb der Schieberplatte (20) und an dieser anliegend eine Blendenplatte (22) vorgesehen;

. . .

k)  die Blendenplatte (22) ist ebenfalls zwischen
    einer ersten und einer zweiten Endstellung hin-
    und hergehend angetrieben und so mit Aussparungen
    (70) versehen, daß sie in ihrer ersten Endstellung die Fenster (66) der Schieberplatte (20)
    in deren gesamten Bewegungsbereich mindestens
    teilweise überdeckt und in ihrer zweiten Endstellung die Fenster (66) nach unten freigibt,
    wenn sich auch die Schieberplatte (20) in ihrer
    zweiten Endstellung befindet;

l)  der Antrieb der Blendenplatte (22) ist so mit
    dem Antrieb der Saugröhrchen (50) und mit dem
    Antrieb der Schieberplatte (20) gekoppelt, daß
    die Blendenplatte (22) ihre zweite Endstellung
    zeitlich nach dem Anlegen der Saugröhrchen an
    die Bauelemente (33) erreicht, und in die erste
    Endstellung gelangt, bevor die Schieberplatte (20)
    ihre erste Endstellung erreicht.

3. Vorrichtung nach Anspruch 1 oder 2, zum Bestücken
von Leiterplatten mit rechteckigen bzw. quadratischen
Bauelementen, dadurch gekennzeichnet, daß auch die
Fenster (66) in der Schieberplatte (20) rechteckig
bzw. quadratisch ausgeführt sind und daß die Verschiebeachse der Schieberplatte (20) im Winkel ($\alpha$ )
zu den Kanten der Fenster (66) verläuft.

4. Vorrichtung nach einem der vorhergehenden Ansprüche,
dadurch gekennzeichnet, daß die Saugröhrchen (50) zwischen den Magazinen (32) angeordnet sind und der Verschiebeweg der Schieberplatte (20) kleiner als die
Rasterteilung (b) der Magazine (32) in Verschieberichtung ist.

...

5. Vorrichtung nach Anspruch 4, dadurch gekennzeichnet, daß die Magazine (32) und die Saugröhrchen (50) reihenweise aufeinanderfolgend angeordnet sind.

6. Vorrichtung nach Anspruch 2, dadurch gekennzeichnet, daß in den Magazinen (32) Gewichtskörper (36) zur Beschwerung der Bauelemente (33) vorgesehen sind.

7. Vorrichtung nach Anspruch 2, dadurch gekennzeichnet, daß die Magazine (32) an ihren Ausgangsöffnungen je mit einer Schiebeführung (41) für einen Verschlußstopfen (39) versehen sind, welche bei eingebautem Magazin (32) parallel zur Verschieberichtung der Schieberplatte (20) verläuft.

8. Vorrichtung nach Anspruch 7, dadurch gekennzeichnet, daß die in der Schiebeführung (41) sitzenden Verschlußstopfen (39) einen über die Öffnungsrandebene der Magazine (32) axial hervorstehenden, dem Fensterprofil der Schieberplatte (20) angepaßten Ansatz (39) haben.

9. Vorrichtung nach Anspruch 7 oder 8, dadurch gekennzeichnet, daß die Schiebeführung an schwalbenschwanzförmigen Aussparungen (41) in zwei gegenüberliegenden Seitenwänden (37, 38) des Magazins (32) gebildet ist.

10. Vorrichtung nach einem der Ansprüche 7 bis 9, dadurch gekennzeichnet, daß die Verschlußstopfen (39) stirnseitig mit Rampenflächen (44) versehen sind.

11. Vorrichtung nach einem der vorhergehenden Ansprüche, dadurch gekennzeichnet, daß die Magazine (32) an mindestens einer Seitenwand (37) einen Längsschlitz (46) haben.

...

0081242

- 6 -

12. Vorrichtung nach einem der vorhergehenden Ansprüche, dadurch gekennzeichnet, daß die Mündungen der Saugröhrchen (50) von elastisch verformbaren Kragen (62) umgeben sind.

13. Vorrichtung nach Anspruch 12, dadurch gekennzeichnet, daß die Kragen (62) durch auf die Saugröhrchen (50) aufgeschobene und über deren Stirnende vorstehende flexible Schläuche (63) gebildet sind.

FIG. 1

0081242

FIG. 2

## FIG. 3

## FIG. 4

## FIG. 5

**FIG.6**

**FIG. 7**

**FIG. 8**

**FIG.9**

17453

0081242

FIG. 10